# EUROPEAN PATENT SPECIFICATION

(11) **EP 4 301 100 B1**
(45) Date of publication and mention of the grant of the patent: **29.10.2025**
(21) Application number: 22182339.6
(22) Date of filing: 30.06.2022
(51) Int. Cl.: H05K 5/02, G06K 19/00, B65D 27/00, B65D 8/00, B67D 1/08

(54) **CONNECTOR FOR CONNECTING AN ELECTRONIC DEVICE, ESPECIALLY AN ELECTRONIC TRACKING DEVICE, TO A CONTAINER, ELECTRONIC ASSEMBLY, CONTAINER ASSEMBLY AND METHOD FOR MOUNTING A CONNECTOR ON A CONTAINER**
VERBINDER ZUM VERBINDEN EINER ELEKTRONISCHEN VORRICHTUNG, INSBESONDERE EINER ELEKTRONISCHEN VERFOLGUNGSVORRICHTUNG, MIT EINEM BEHÄLTER, ELEKTRONISCHE ANORDNUNG, BEHÄLTERANORDNUNG UND VERFAHREN ZUM MONTIEREN EINES VERBINDERS AN EINEM BEHÄLTER
CONNECTEUR POUR CONNECTER UN DISPOSITIF ÉLECTRONIQUE, EN PARTICULIER UN DISPOSITIF DE SUIVI ÉLECTRONIQUE À UN RÉCIPIENT, ENSEMBLE ÉLECTRONIQUE, ENSEMBLE RÉCIPIENT ET PROCÉDÉ DE MONTAGE D'UN CONNECTEUR SUR UN RÉCIPIENT

(43) Date of publication of application: 03.01.2024
(73) Proprietor: ALPS Electric (Ireland) Ltd., Co. Cork (IE)
(72) Inventor: MCCORMACK, Stephen, Co. Cork (IE); MURPHY, Alan, Co. Cork (IE)
(74) Representative: Maiwald GmbH

(56) References cited:
- US-A1- 2020 005 112
- US-B2- 11 365 110

## Description

The invention relates to a connector for connecting an electronic device, especially an electronic tracking device, to a container having a rounded cross-section.

The invention is additionally directed to an electronic assembly for a container having a rounded cross-section. The electronic assembly comprises a connector as mentioned above.

The invention further relates to a container assembly. The container assembly comprises a container with a storage volume being delimited by a circumferentially closed shell defining a rounded cross-section and an end plate being arranged at an end of the shell. A circumferentially closed collar extends from the end plate on a side being opposed to the storage volume. The collar has a rim portion being bent towards an interior of the collar. The container assembly additionally comprises a connector as mentioned above.

The invention is also directed to a method for mounting a connector as mentioned above on a container with a storage volume being delimited by a circumferentially closed shell defining a rounded cross-section and an end plate. The end plate is arranged at an end of the shell. A circumferentially closed collar extends from the end plate on a side being opposed to the storage volume, wherein the collar has a rim portion being bent towards an interior of the collar.

**In** the present context, a container having a rounded cross-section may be a keg or a gas cylinder. When using such containers, it may be desirable to attach an electronic device, e.g. an electronic tracking device, to the container. This has the advantage that the container can be tracked. Alternatively or additionally, data relating to the container or the content of the container may be stored on the electronic device. Further alternatively or additionally, the electronic device may be configured to establish a wireless data connection to other electronic devices. Such a data connection may be used to read data from the electronic device on the container and/or to write data on the electronic device on the container.

In this context, US 2020/0005112 A1 discloses a connector according to the preamble of claim 1, for connecting an electronic device to a container.

Independent from the specific functionality of the electronic device, it has been found that, mounting an electronic device on a container is rather tedious. Furthermore, rather complex and expensive means have to be used for attaching the electronic device to the container. This is mainly due to the rounded cross-section of the container.

It is therefore an objective of the present invention to provide an improved solution for mounting an electronic device on a container having a rounded cross-section. The invention is solely defined by appended independent claims. Preferred embodiments are defined in dependent claims.

The problem is solved by a connector for connecting an electronic device, especially an electronic tracking device, to a container having a rounded cross-section. The connector comprises a support structure being configured to support the electronic device. Moreover, the connector comprises a first engagement wall extending from a first end of the support structure and being configured to engage a rim portion of a collar of the container. Additionally, the connector comprises a second engagement wall extending from a second end of the support structure and being configured to engage a connection region of the container between an end plate of the container and the collar. The support structure further comprises a hinging means allowing the connector to selectively assume a flexed state and an extended state. In the flexed state, a distance between a free end of the first engagement wall and a free end of the second engagement wall is smaller than in the extended state. The first end of the support structure and the second end of the support structure are arranged opposite one another. Using the first engagement wall and the second engagement wall, the connector may be reliably attached to the container by mounting it between the rim portion of the collar and the connection region. The hinging means facilitates the mounting and dismounting of the connector since the connecter can be selectively put into the flexed state. Due to the comparatively small distance between the free end of the first engagement wall and the free end of the second engagement wall in this state, the connector can be easily maneuvered in restricted spaces such as an environment of the collar of the container. When the connector is mounted on the container, it preferably assumes the extended state. The connector may be transitioned between the flexed state and the extended state by operating the hinging means. Also the transition between the extended state and the flexed state is performed by operating the hinging means. Thus, the connector is structurally simple and easy to install at the same time.

According to the invention, the support structure comprises a plate-shaped mounting section which is configured to support the electronic device when the electronic device is mounted to the connector. Consequently, the electronic device may be securely mounted on the connector. Moreover, the plate-shaped mounting section offers the possibility to use a so-called tamper-proof electronic device. Such a device has a switch on the lower side which is held in a pre-defined switching state by the plate-shaped mounting section. Tampering is detected, if this switch changes its switching state. This functionality may only be provided with the necessary reliability on a plate-shaped mounting section. Otherwise, the risk of an erroneous tampering detection is elevated.

Further according to the invention, the hinging means divides the plate-shaped mounting section in two portions. In general, the location of the hinging means within the plate-shaped mounting section may be freely chosen. However, in a preferred solution, the hinging means is provided at a certain distance from both the first end and the second end of the support structure. Especially, when considering a distance between a first end of the plate-shaped mounting section being arranged in proximity to the first end of the support structure and a second end of the plate-shaped mounting section being arranged in proximity to the second end of the support structure, the hinging means is arranged outside the first 10% and outside the last 10% of this distance. **In** other words, the hinging means is arranged in a range between 10% and 90% of this distance. More preferably, the hinging means is arranged in a range between 30% and 70% of this distance. **In** a special case, the hinging means is arranged at 50% of this distance, i.e. in the middle. Such an arrangement of the hinging means has the effect that the connector may be reliably transferred between the flexed state and the extended state.

According to an example, the hinging means comprises a hinging rod being rotatably supported on at least a portion of the support structure. Alternatively, the hinging means comprises a section of elastically deformable material. A hinging means comprising a hinging rod may also be designated as an assembled hinging mechanism. Such a mechanism comprises a plurality of parts which interact with each other for providing the hinging functionality. Such hinging means are simple and robust. A hinging means comprising a section of elastically deformable material may be designated as an integral hinge. Such a hinge does not require assembling steps since it may be produced together with the support structure in an integral manner. This is very efficient from a production perspective.

The hinging means may fully extend over a width of the support structure. This means that the hinging means extends from a third end of the support structure to a fourth end of the support structure. **In** this context, each of the third end and the fourth end spans between the first end and the second end. The third end and the fourth end are arranged opposite one another. Thus, the hinging means covers the fully width which is geometrically available on the support structure. Such a hinging means is comparatively stable and durable.

**In** an alternative, the hinging means extends over a portion of the width of the support structure only. Such a comparatively small hinging means requires the use of comparatively little material. Consequently, the connector may be manufactured in a cost-efficient manner and may be light weight.

It is also possible that the hinging means comprises a plurality, i.e. at least two, hinging sections which are distributed over a portion of the width of the support structure or over the full width of the support structure. Distributed hinging sections also allow for a mechanically stable hinging mechanism. The use of material may be adjusted by adjusting the number and size of the sections.

In an embodiment, at least one of the first engagement wall and the second engagement wall comprises at least one curved section. This also covers cases in which at least one of the first engagement wall and the second engagement wall are curved in their entirety. In this context, a radius of curvature of the curved section corresponds exactly or roughly to a radius of curvature of the portion of the container, where the connector is to be mounted. This leads to a particularly stable connection between the first engagement wall and/or the second engagement wall and the respective portion of the container.

In a preferred variant, both the first engagement wall and the second engagement wall comprise a curved section. The radius of curvature of the curved section of the first engagement wall and the radius of curvature of the curved section of the second engagement wall may be the same.

In a case in which the radius of curvature only corresponds roughly to a radius of curvature of the associated portion of the container, the first engagement wall and/or the second engagement wall may be elastically deformable such that the respective curved section can be adapted to the radius of curvature of the corresponding portion of the container by elastic deformation.

A radius of curvature of a curved section which only roughly corresponds to a radius of curvature of a corresponding portion of the container may differ by +/- 20 % from the radius of curvature of the corresponding portion of the container.

Preferably, the radius of curvature of the at least one curved section extends substantially perpendicular to a pivot axis of the hinging means. In such a configuration, the distance between a free end of the first engagement wall and a free end of the second engagement wall can be altered in a substantial manner by transitioning the connector from the flexed state into the extended state or vice versa. Consequently, the connector may be easily mounted on the container.

In a further example, at least one of the first engagement wall and the second engagement wall comprises an insertion slope being arranged at a free end of the respective engagement wall which is opposite to the support structure. Using the insertion slope, the engagement of the first engagement wall with the rim portion of the collar of the container and/or the engagement of the second engagement wall with the connection region of the container is facilitated.

Preferably, both the first engagement wall and the second engagement wall comprise an insertion slope.

In a case in which at least one of the first engagement wall and the second engagement wall comprises a curved section, an axial direction of the curved section may be parallel to a first direction defining the plate-shaped mounting section when the connector is in the extended state. Such a connector is compact. Moreover, sufficient space is provided for the plate-shaped mounting section and thus, for an electronic device.

According to a variant, the support structure comprises at least one holding means for holding the electronic device on the support structure, when the electronic device is mounted to the connector. Thus, the electronic device may be reliably secured on the support structure. Examples of holding means include but are not limited to a clipping hook, an opening for a cable tie, a hole for a screw or a surfaces for an adhesive tape or an adhesive compound.

In an example, at least one holding means is arranged in each of the portions of the plate-shaped mounting section. Thus, the electronic device may be secured on the support structure in a particularly reliable manner. Moreover, this configuration allows the use of the electronic device for immobilizing the hinging mechanism. This means that the hinging mechanism cannot be operated if the electronic device is secured on each of the portions of the plate-shaped mounting section using the respective holding means.

It is also possible that the support structure comprises at least one positioning means for positioning the electronic device in a pre-defined position on the support structure. This facilitates securing the electronic device in the predefined position. The positioning means for example comprises a positioning rib.

The connector may also comprise at least one blocking means for blocking the hinging means in at least the extended state. Thus, the hinging means may be selectively immobilized in the extended state. As has already been explained, the blocking means may be formed by the electronic device. However, it is also possible to provide a blocking means which is separate from the electronic device. The effect is the same. If the electronic device is used as a blocking means, comparatively few parts are necessary.

The problem is additionally solved by an electronic assembly for a container having a rounded cross-section. The electronic assembly comprises a connector according to the invention and an electronic device, especially an electronic tracking device. The electronic device is mounted on the support structure of the connector. In a case in which the electronic device is a tracking device, the electronic assembly may be designated as a tracker assembly. The electronic assembly may be mounted to the connector using the first engagement wall and the second engagement wall of the connector. Thus, the electronic assembly may be mounted in a simple, reliable and quick manner on a container having a rounded cross-section.

According to an embodiment, the connector is in the extended state and the electronic device immobilizes the hinging means in the extended state. In such a condition, the electronic device may be mounted on the container in a particularly reliable manner. Only comparatively few parts are necessary.

Furthermore, the problem is solved by a container assembly. The container assembly comprises a container with a storage volume being delimited by a circumferentially closed shell defining a rounded cross-section and an end plate being arranged at an end of the shell. A circumferentially closed collar extends from the end plate on a side being opposed to the storage volume. The collar has a rim portion being bent towards an interior of the collar. The container assembly additionally comprises a connector according to the invention. The first engagement wall of the connector engages the rim portion of the collar and the second engagement wall of the connector engages a connection region of the container between the end plate of the container and the collar. Thus, using the connector, an electronic assembly may be mounted on the container in a simple, reliable and quick manner. In this context, the region being defined by the collar of the container may also be called a chime. It is noted that the connector is in the extended state when the first engagement wall of the connector engages the rim portion of the collar and the second engagement wall of the connector engages a connection region of the container. Preferably, a height of the connector, i.e. a distance between a free end of the first engagement wall and a free end of the second engagement wall, corresponds to a height of the collar. It is also possible to mount the connector in a condition in which the connector is under pressure or under tension. In this case, a height of the connector, i.e. a distance between a free end of the first engagement wall and a free end of the second engagement wall, is slightly bigger as compared to a height of the collar. Since the rim portion forms an undercut being effective along a direction from a circumference of the collar towards an interior of the collar and/or being effective in a direction being oriented away from the end plate, the connector is mounted on the container in a reliable manner.

Also the connection region forms an undercut being effective along a direction from a circumference of the collar towards an interior of the collar if the end plate is domed towards an exterior of the storage volume.

As has already been mentioned before, the container may be a keg or a gas cylinder. The keg may be designed according to at least one of the standards "Euro", "DIN" or "slim". Of course, it is also possible that the keg is custom-built or corresponds to a standard being proprietary to a certain company or organization.

The container assembly may further comprise an electronic device, especially an electronic tracking device, wherein the electronic device is mounted on the support structure of the connector. In other words, the electronic assembly according to the invention is attached to the container.

In this context, the electronic device may immobilize the hinging means in the extended state. Thus, as has already been explained before, the electronic device is attached on the container in a reliable and simple manner. This solution uses especially few parts to achieve this attachment.

The problem is also solved by a method for mounting a connector according to the invention on a container with a storage volume being delimited by a circumferentially closed shell defining a rounded cross-section and an end plate. The end plate is arranged at an end of the shell. A circumferentially closed collar extends from the end plate on a side being opposed to the storage volume. The collar has a rim portion being bent towards an interior of the collar. The method comprises:
- providing the connector in a flexed state or transferring the connector to the flexed state,
- arranging a free end of the first engagement wall under the rim portion or in proximity to the rim portion, and/or arranging a free end of the second engagement wall in a connection region of the container between the end plate of the container and the collar or in proximity to the connection region,
- transferring the connector to the extended state such that the first engagement wall engages the rim portion and the second engagement wall engages the connection region.

When the connector is in the flexed state, a distance between a free end of the first engagement wall and a free end of the second engagement wall is smaller than a height of the collar. Consequently, the connector may be easily maneuvered into the location where it is to be attached to the container or in proximity to this location. Transferring the connector to the extended state is a comparatively simple activity. Thereby, the first engagement wall and the second engagement wall contact the corresponding portions of the container where the connector is to be attached. This may be performed very quickly.

The method may further comprise mounting an electronic device, especially an electronic tracking device, on the support structure such that the electronic device immobilizes the connector in the extended state. As has been explained before, the mounting of the electronic device on the support structure has two aspects. The first aspect consists in the fact that, in doing so, the electronic device is reliably attached to the container via the connector. The second aspect consists in the fact that by immobilizing the hinging means in the extended state, the connector is secured on the container. This is simple and efficient. Very few parts are necessary.

Since in the above embodiment, the method comprises mounting the electronic device, this embodiment may also be designated as a method for mounting an electronic device, especially an electronic tracking device, on a container.

It is noted that all advantages and effects which have been explained for one aspect of the invention also apply mutatis mutandis to all other aspects of the invention.

It is further noted that the connector may be adapted to different containers, e.g. different kegs or different gas cylinders. This may be done by adjusting a distance between a free end of the first engagement wall and a free end of the second engagement wall accordingly. Additionally or alternatively, if applicable, a radius of curvature of a curved section of at least one of the first engagement wall and the second engagement wall may be adapted.

It is also possible to adapt the connector to different electronic devices. In order to do so, a size of the plate-shaped mounting section may be adapted accordingly. Moreover, a number, position and size of holding means may be adapted in a suitable manner.

Examples of the disclosure will be described in the following with reference to the drawings.
- Figure 1: shows a container assembly according to the invention, comprising an electronic assembly according to the invention and a connector according to the invention, wherein the connector has been mounted on the container using a method according to the invention,
- Figure 2: shows a more detailed view of the container assembly of Figure 1,
- Figure 3: shows a view corresponding to the view of Figure 2, wherein only the connector and no electronic device is attached to the container,
- Figure 4: shows a sectional view of the container assembly of figure 2 along plane IV,
- Figure 5: shows the electronic assembly of Figures 1, 2 and 4 in an isolated representation,
- Figure 6: shows a detail of the electronic assembly of Figure 5 seen along direction VI of Figure 5,
- Figure 7: shows the electronic assembly of Figure 5 in an exploded view
- Figure 8: shows an alternative configuration of an electronic assembly according to the invention,
- Figure 9: shows the connector of Figure 1 in an isolated perspective representation,
- Figure 10: shows the connector of Figure 9 from a different perspective,
- Figure 11: shows the container assembly of Figure 1 in a situation during the performance of the method according to the invention, and
- Figure 12: shows the container assembly of Figure 1 in a different situation during the performance of the method according to the invention.

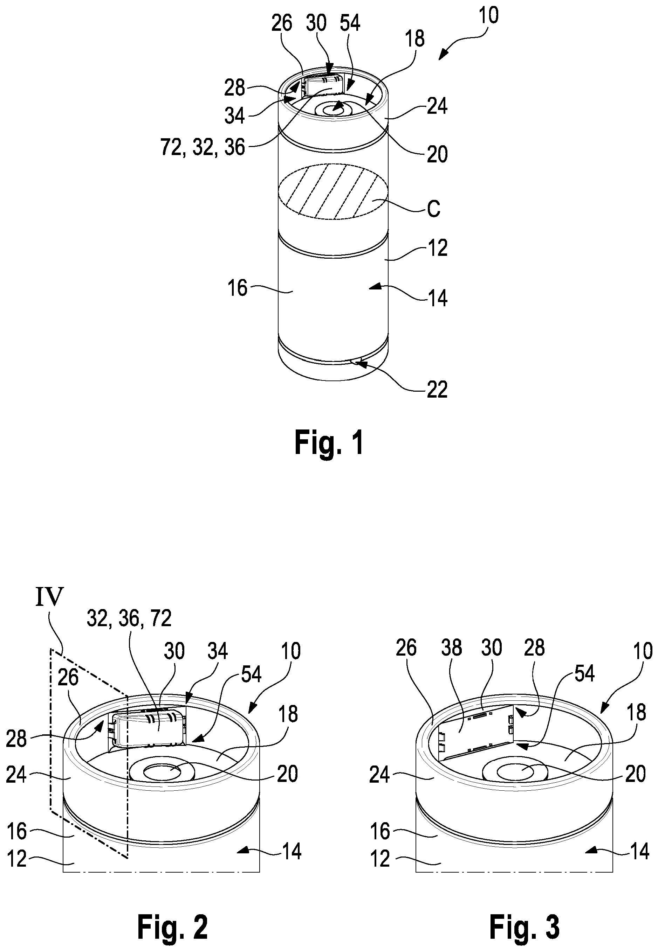

Figures 1 to 4 show a container assembly 10.

The container assembly 10 comprises a container 12.

In this example, the container is a keg. More specifically, the container is a so-called slim keg. For this reason, the terms keg and container will be used interchangeably when describing the Figures.

The container 12 has a storage volume 14 being delimited by a circumferentially closed shell 16.

The circumferentially closed shell 16 generally defines a rounded cross-section C (see especially Figure 1). The kegs represented in the Figures have a circular cross-section C.

Moreover, the storage volume 14 is delimited by a first end plate 18 which is an upper end plate in the representation of the Figures. The first end plate 18 is arranged at a first axial end of the shell 16.

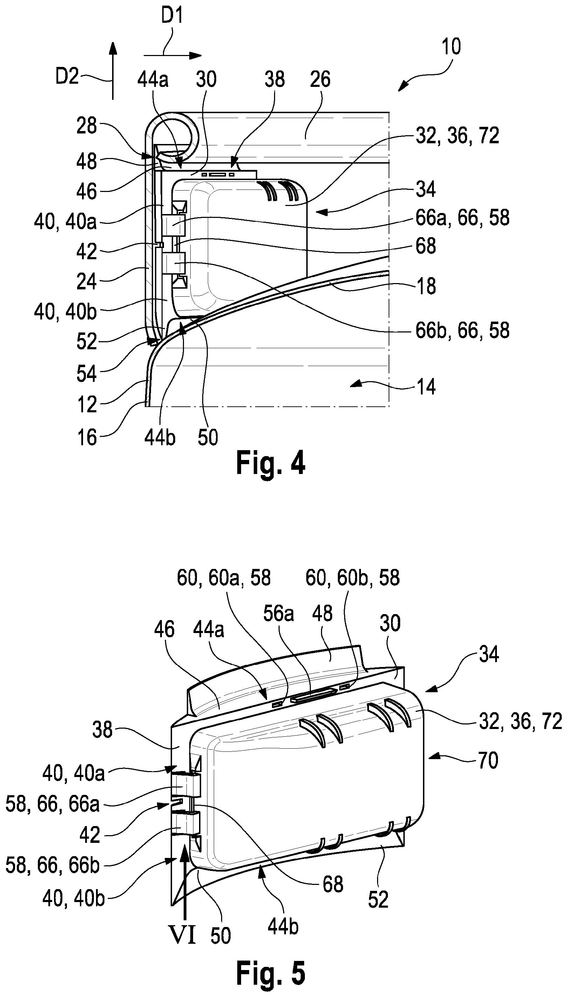

The first end plate 18 is domed towards an outside of the storage volume 14 (see especially Figure 4).

At a center of the first end plate 18, a nozzle 20 is arranged. The storage volume 14 is accessible through the nozzle 20.

At a second axial end of the shell 16, a second end plate 22 is arranged. The second axial end is arranged opposite to the first axial end. Thus, the second end plate 22 is arranged opposite the first end plate 18. The second end plate 22 may be called a lower end plate.

Consequently, the storage volume 14 is delimited by the shell 16, the first end plate 18 and the second end plate 22.

Also the second end plate 22 is domed towards an outside of the storage volume 14.

Furthermore, a circumferentially closed collar 24 extends from the first end plate 18 on a side being opposed to the storage volume 14.

The collar 24 has a rim portion 26 being bent towards an interior of the collar 24 (see especially Figure 4).

The rim portion 26 forms an undercut 28 being effective along a direction D1 from a circumference of the collar 24 towards an interior of the collar 24 and in a direction D2 being oriented away from the first end plate 18 (cf. Figure 4).

Such containers 12 or kegs are for example used to store and/or transport beverages.

The container assembly 10 additionally comprises a connector 30 and an electronic device 32.

The electronic device 32 is mounted on the connector 30 and the connector 30 is mounted on the container 12 as will be explained in detail further below. Thus, the electronic device 32 is attached to the container 12 via the connector 30.

The connector 30 and the electronic device 32 together form an electronic assembly 34.

In the examples shown in the Figures, the electronic device is an electronic tracking device 36.

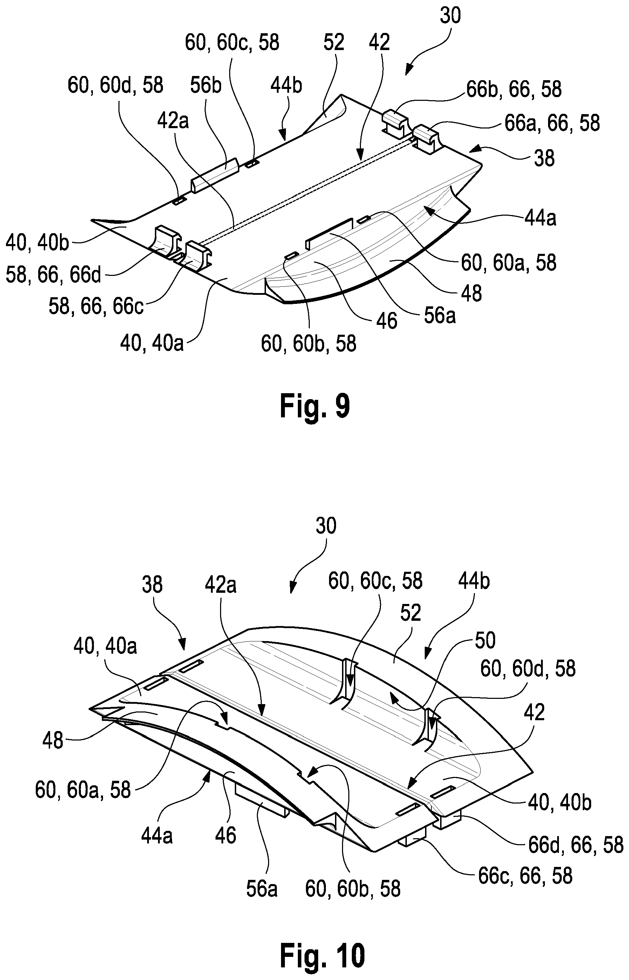

The connector 30, the electronic device 32 and the electronic assembly 34 are explained in the following with special reference to Figures 5 to 10.

The connector 30 comprises a support structure 38.

The support structure 38 has a plate-shaped mounting section 40 which is configured to support the electronic device 32, more specifically the electronic tracking device 36, when being mounted to the connector 30.

The plate-shaped mounting section 40 is divided in two portions 40a, 40b by a hinging means 42.

In the present examples, the hinging means comprises a section 42a of elastically deformable material. Thus, the hinging means is formed as an integral hinge. It extends over a full width of the plate-shaped mounting section 40.

It is noted that as an alternative to the integral hinge also an assembled hinge comprising a hinging rod may be used.

Moreover, at a first end 44a of the support structure 38, a first connection wall 46 is provided which extends substantially perpendicular from the plate-shaped mounting section 40.

On the connection wall 46, a first engagement wall 48 is arranged. Thus, the first engagement wall 48 extends from the first end 44a of the support structure 38.

The first engagement wall 48 is configured to engage the rim portion 26 of the collar 24.

The first engagement wall 48 is curved, wherein a radius of curvature corresponds to a radius of curvature of the collar 24.

Moreover, the radius of curvature of the first engagement wall 48 extends substantially perpendicular to the plate-shaped mounting section 40.

At a second end 44b of the support structure 38, a second connection wall 50 is provided which extends substantially perpendicular from the plate-shaped mounting section 40.

The first connection wall 46 and the second connection wall 50 extend to the same side of the plate-shaped mounting section 40.

On the second connection wall 50, a second engagement wall 52 is arranged. Thus, the second engagement wall 52 extends from the second end 44b of the support structure 38.

The second engagement wall 52 is configured to engage a connection region 54 of the container 12 being formed between the first end plate 18 the collar 24. More precisely, the connection region 54 is the region where the first end plate 18 is joint to the collar 24.

Also the second engagement wall 52 is curved, wherein a radius of curvature corresponds to a radius of curvature of the collar 24.

As before, the radius of curvature of the second engagement wall 52 extends substantially perpendicular to the plate-shaped mounting section 40.

Since the first engagement wall 48 and the second engagement wall 52 are arranged on opposite sides of the hinging means 42, a distance between respective free ends of the first engagement wall 48 and the second engagement wall 52 can be adapted using the hinging means 42.

More precisely, using the hinging means 42, the connector 30 can assume an extended state in which the distance between the first engagement wall 48 and the second engagement wall 52 assumes a maximum. In this state, the portion 40a and the portion 40b of the plate-shaped mounting section 40 are arranged in a common plane.

Moreover, the hinging means 42 can be flexed such that the portion 40a and the portion 40b of the plate-shaped mounting section 40 enclose an angle of less than 180 degrees. This state can be designated as a flexed state of the connector 30. In the flexed state, a distance between the free end of the first engagement wall 48 and the free end of the second engagement wall 52 is smaller than in the extended state.

For mounting the electronic device 32 on the plate-shaped mounting section 40, two positioning means 56a, 56b are provided on the plate-shaped mounting section 40.

In the examples shown in the Figures, the positioning means 56a, 56b are formed as positioning ribs extending from a support surface of the plate-shaped mounting section 40.

A distance between the two positioning means 56a, 56b is configured such that it corresponds to a width of the electronic device 32. Thus, when arranging the electronic device 32 between the positioning means 56a, 56a, a movement of the electronic device 32 in a direction from the first end 44a towards the second end 44b or vice versa is blocked.

It is noted that the positioning means 56a is arranged on the portion 40a of the plate-shaped mounting section 40 and the positioning means 56b is arranged on the portion 40b of the plate-shaped mounting section 40.

Moreover, the support structure 38 comprises several holding means for holding the electronic device 32 on the support structure 38. The holding means are generally designated by reference sign 58.

The support structure 38 comprises holding means 60 of a first type which are formed as openings 60a, 60b, 60c, 60d.

The openings 60a, 60b, 60c, 60d are formed and sized such that they can receive a standard cable tie.

In the example shown in the Figures openings 60a, 60b are arranged on the plate-shaped mounting section 40 at an end adjacent to the first connection wall 46 and openings 60c, 60d are arranged on the plate-shaped mounting section 40 at an end adjacent to the second connection wall 50.

Consequently, openings 60a, 60b are arranged on the portion 40a of the plate-shaped mounting section 40 and openings 60c, 60d are arranged on the portion 40b of the plate-shaped mounting section 40.

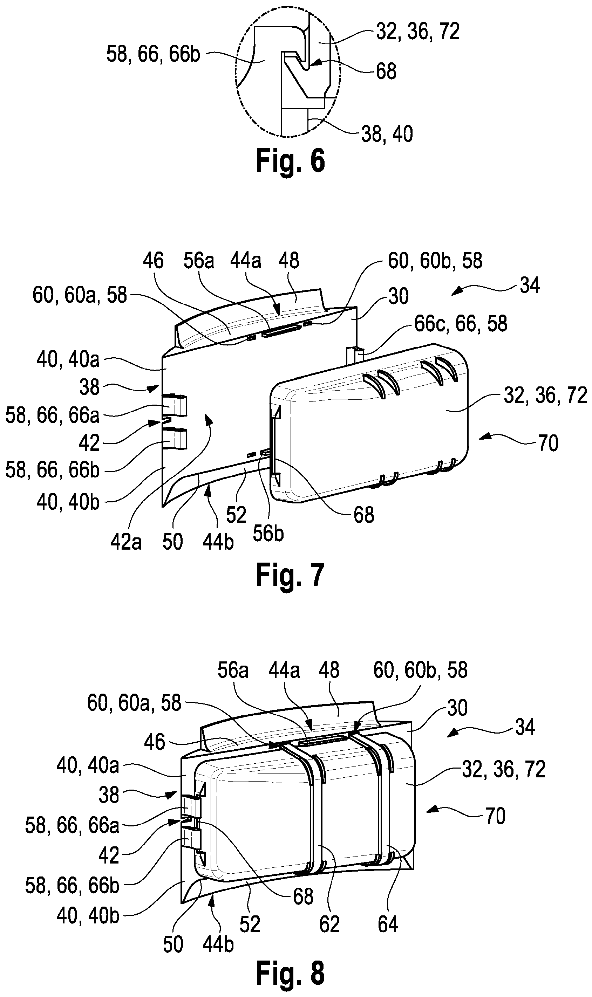

Thus, the electronic device 32 may be mounted on the connector 30 by a first cable tie 62 which extends from a back side of the plate-shaped mounting section 40 through opening 60a, around the electronic device 32, through opening 60c back to the back side of the of plate-shaped mounting section 40 (see example of Figure 8).

Moreover, the electronic device 32 may be mounted on the connector 30 by a second cable tie 64 which extends from a back side of the plate-shaped mounting section 40 through opening 60b, around the electronic device 32, through opening 60d back to the back side of the of plate-shaped mounting section 40 (see example of Figure 8).

Furthermore, the support structure 38 comprises holding means 66 of a second type which are formed as elastic hooks 66a, 66b, 66c, 66d.

Hooks 66a, 66b are arranged at a third end of the support structure 38 which spans between the first end 44a and the second end 44b.

Hooks 66c, 66d are arranged at a fourth end of the support structure 38 which spans between the first end 44a and the second end 44b and, at the same time, is arranged opposite the third end.

Hooks 66a, 66b are configured to engage a first holding rib 68 which is provided on the electronic device 32 and hooks 66c, 66d are configured to engage a second holding rib 70.

Again, hooks 66a, 66c are arranged on the portion 40a and hooks 66b, 66d are arranged on the portion 40b of the plate-shaped mounting section 40.

It is noted that the electronic device 32 may be mounted on the connector 30 using the holding means 60 of the first type only, the holding means 66 of the second type only or both the holding means 60 of the first type and the holding means 66 of the second type.

The connector 30 also comprises a blocking means 72 which is configured to block the hinging means 42 in the extended state. In the present example, the electronic device 32 forms the blocking means 72.

In a situation in which the electronic device 32 is mounted on the connector 30 using either the holding means 60 of the first type or the holding means 66 of a second type or both, the hinging means 42 cannot move out of the extended state.

In other words, the electronic device 32 immobilizes the hinging means 42 when it is mounted on the support structure 38.

In a situation in which the connector 30 or the connector 30 and the electronic device 32 are mounted on the container 12, the first engagement wall 48 engages the rim portion 26. Moreover, the second engagement wall 52 engages the connection region 54.

Thus, in the extended state of the connector 30, a distance between the free end of the first engagement wall 48 and the free end of the second engagement wall 52 corresponds to a height of the collar 24 which is defined as a distance between the connection region 54 and the undercut 28.

Consequently, the electronic device 32 which is an electronic tracking device 36 in the present disclosure is reliably attached to the container 12.

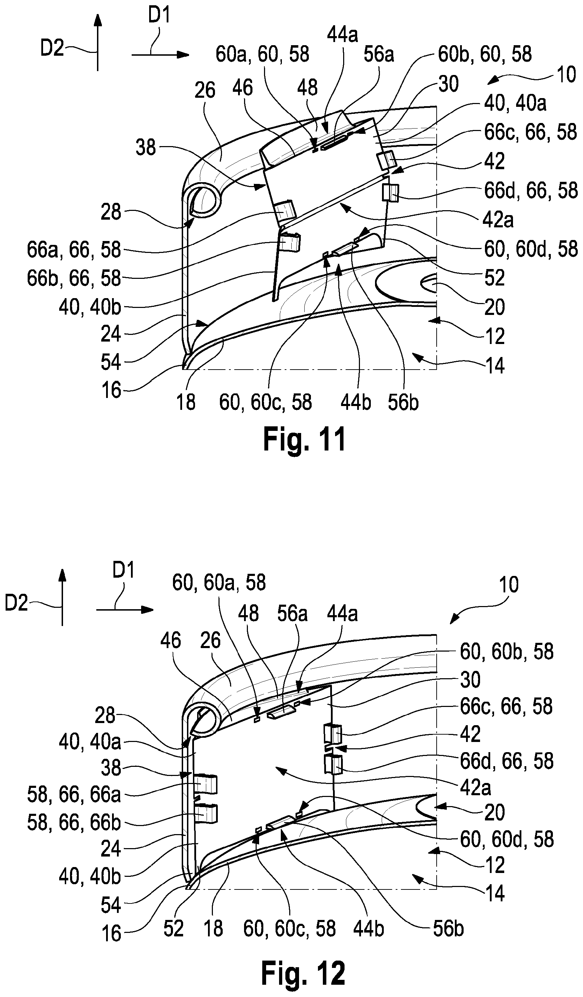

In order to reach such a situation, the connector 30 may be mounted on the container 12 using a method for mounting a connector 30 on a container 12. This will be explained in the following with special reference to Figures 11 and 12.

The method comprises providing the connector 30 in the flexed state (cf. Figure 11). In a case in which the connector 30 is not in the flexed state, it is transferred into the flexed state.

In the flexed state, the connector 30 is comparatively compact such that it can be easily maneuvered in the surroundings of the first and plate 18 and the collar 24.

Thereafter, the free end of the first engagement wall 48 is arranged under the rim portion 26 or in proximity to the rim portion. In the example shown in the Figures, the free end of the first engagement wall 48 is arranged in the undercut 28.

The free end of the second engagement wall 52 is arranged in proximity to the connection region 54. In the present example, the free end of the second engagement wall 52 is abutted against the collar 24 at a position above the connection region 54.

Subsequently, the connector 30 is transferred into the extended state such that the first engagement wall 48 engages the rim portion 26 and the second engagement wall 52 engages the connection region 54. As has already been mentioned before, this is possible since the distance between the free end of the first engagement wall 48 and the free end of the second engagement wall 52 corresponds to the height of the collar 24.

Thereafter, the electronic device 32 is mounted on the support structure 38. To this end, the holding means 60 of the first type or the holding means 66 of the second type may be used. It is also possible to use the holding means 60, 66 of both types. Consequently, the electronic device 32 immobilizes the connector 30 in the extended state and the connector 30 and the electronic device 32 are securely attached to the container 12.

It is noted that the method may be varied especially in connection with the arrangement of the free ends of the engagement walls 48, 52.

In an alternative, the free end of the second engagement wall 52 is arranged in the connection region 54 and the free end of the first engagement wall 48 is abutted against the collar 24 in proximity to the rim portion 26, i.e. slightly below the rim portion 26 before the connector 30 is transferred into the extended state.

It is also possible to abut both free ends of the first engagement wall 48 and the second engagement wall 52 on the collar 24, wherein the free end of the first engagement wall 48 is arranged in proximity to the rim portion 26 and the second engagement wall 52 is arranged in proximity to the connection region 54. Thereafter, the connector 30 is transferred into the extended state.

### Reference Signs

- 10: container assembly
- 12: container
- 14: storage volume
- 16: shell
- 18: first end plate
- 20: nozzle
- 22: second end plate
- 24: collar
- 26: rim portion
- 28: undercut
- 30: connector
- 32: electronic device
- 34: electronic assembly
- 36: electronic tracking device
- 38: support structure
- 40: plate-shaped mounting section
- 40a: portion of the plate-shaped mounting section
- 40b: portion of the plate-shaped mounting section
- 42: hinging means
- 42a: section of elastically deformable material
- 44a: first end of the support structure
- 44b: second end of the support structure
- 46: first connection wall
- 48: first engagement wall
- 50: second connection wall
- 52: second engagement wall
- 54: connection region
- 56a: positioning means
- 56b: positioning means
- 58: holding means
- 60: holding means of a first type
- 60a: opening
- 60b: opening
- 60c: opening
- 60d: opening
- 62: first cable tie
- 64: second cable tie
- 66: holding means of a second type
- 66a: hook
- 66b: hook
- 66c: hook
- 66d: hook
- 68: first holding rib
- 70: second holding rib
- 72: blocking means

- C: cross section
- D1: direction
- D2: direction

## Claims

1. Connector (30) for connecting an electronic device (32), especially an electronic tracking device (36), to a container (12) having a rounded cross-section (C), the connector (30) comprising:
a support structure (38) being configured to support the electronic device (32),
a first engagement wall (48) extending from a first end (44a) of the support structure (38) and being configured to engage a rim portion (26) of a collar (24) of the container (12), and
a second engagement wall (52) extending from a second end (44b) of the support structure (38) and being configured to engage a connection region (54) of the container (12) between an end plate (18) of the container (12) and the collar (24),
wherein the support structure (38) comprises a hinging means (42) allowing the connector (30) to selectively assume a flexed state and an extended state, wherein in the flexed state a distance between a free end of the first engagement wall (48) and a free end of the second engagement wall (52) is smaller than in the extended state,
**characterized in that** the support structure (38) comprises a plate-shaped mounting section (40) which is configured to support the electronic device (32) when the electronic device (32) is mounted to the connector (30), wherein the hinging means (42) are configured to divide the plate-shaped mounting section (40) in two portions (40a, 40b).

2. Connector (30) according to claim 1, wherein the hinging means (42) comprises a hinging rod being rotatably supported on at least a portion of the support structure (38) or wherein the hinging means (42) comprises a section (42a) of elastically deformable material.

3. Connector (30) according to any one of the preceding claims, wherein at least one of the first engagement wall (48) and the second engagement wall (52) comprises at least one curved section.

4. Connector (30) according to any one of the preceding claims, wherein the support structure (38) comprises at least one holding means (58, 60, 66) for holding the electronic device (32) on the support structure (38), when the electronic device (32) is mounted to the connector (30).

5. Connector (30) according to claim 4, wherein at least one holding means (58, 60, 66) is arranged in each of the portions (40a, 40b) of the plate-shaped mounting section (40).

6. Connector (30) according to any one of the preceding claims, wherein the connector (30) comprises at least one blocking means (72) for blocking the hinging means (42) in at least the extended state.

7. Electronic assembly (34) for a container (12) having a rounded cross-section (C), comprising
a connector (30) according to any one of the preceding claims, and
an electronic device (32), especially an electronic tracking device (36), wherein the electronic device (32) is mounted on the support structure (38) of the connector (30).

8. Electronic assembly (34) according to claim 7, wherein the connector (30) is in the extended state and the electronic device (32) immobilizes the hinging means (42) in the extended state.

9. Container assembly (10), comprising
a container (12) with a storage volume (14) being delimited by a circumferentially closed shell (16) defining a rounded cross-section (C) and an end plate (18) being arranged at an end of the shell (16), and a circumferentially closed collar (24) extending from the end plate (18) on a side being opposed to the storage volume (14), wherein the collar (24) has a rim portion (26) being bent towards an interior of the collar (24), and
a connector (30) according to any one of claims 1 to 6,
wherein the first engagement wall (48) engages the rim portion (26) of the collar (24), and
wherein the second engagement wall (52) engages a connection region (54) of the container (12) between the end plate (18) of the container (12) and the collar (24).

10. Container assembly (10) according to claim 9, further comprising an electronic device (32), especially an electronic tracking device (36), wherein the electronic device (32) is mounted on the support structure (38) of the connector (30).

11. Container assembly (10) according to claim 9 or 10, wherein the electronic device (32) immobilizes the hinging means (42) in the extended state.

12. Method for mounting a connector (30) according to any one of claims 1 to 6 on a container (12) with a storage volume (14) being delimited by a circumferentially closed shell (16) defining a rounded cross-section (C) and an end plate (18), wherein the end plate (18) is arranged at an end of the shell (16), and a circumferentially closed collar (24) extending from the end plate (18) on a side being opposed to the storage volume (14), wherein the collar (24) has a rim portion (26) being bent towards an interior of the collar (24), comprising:
- providing the connector (30) in a flexed state or transferring the connector (30) to the flexed state,
- arranging a free end of the first engagement wall (48) under the rim portion (26) or in proximity to the rim portion (26), and/or arranging a free end of the second engagement wall (52) in a connection region (54) of the container (12) between the end plate (18) of the container (12) and the collar (24) or in proximity to the connection region (54),
- transferring the connector (30) to the extended state such that the first engagement wall (48) engages the rim portion (26) and the second engagement wall (52) engages the connection region (54).

13. The method according to claim 12, further comprising mounting an electronic device (32), especially an electronic tracking device (36), on the support structure (38) such that the electronic device (32) immobilizes the connector (30) in the extended state.

## Patentansprüche

1. Verbinder (30) zum Verbinden einer elektronischen Vorrichtung (32), insbesondere einer elektronischen Verfolgungsvorrichtung (36), mit einem Behälter (12), der einen gerundeten Querschnitt (C) aufweist, wobei der Verbinder (30) umfasst:
eine Stützstruktur (38), die dazu eingerichtet ist, die elektronische Vorrichtung (32) zu stützen,
eine erste Eingriffnahmewand (48), die sich von einem ersten Ende (44a) der Stützstruktur (38) erstreckt und dazu eingerichtet ist, einen Randabschnitt (26) eines Bundes (24) des Behälters (12) in Eingriff zu nehmen, und
eine zweite Eingriffnahmewand (52), die sich von einem zweiten Ende (44b) der Stützstruktur (38) erstreckt und dazu eingerichtet ist, eine Verbindungsregion (54) des Behälters (12) zwischen einer Endplatte (18) des Behälters (12) und dem Bund (24) in Eingriff zu nehmen,
wobei die Stützstruktur (38) ein Scharniermittel (42) umfasst, die es dem Verbinder (30) erlaubt, wahlweise einen gebogenen Zustand und einen gestreckten Zustand einzunehmen, wobei im gebogenen Zustand eine Distanz zwischen einem freien Ende der ersten Eingriffnahmewand (48) und einem freien Ende der zweiten Eingriffnahmewand (52) kleiner ist als im gestreckten Zustand,
**dadurch gekennzeichnet, dass** die Stützstruktur (38) eine plattenförmige Montagesektion (40) umfasst, die dazu eingerichtet ist, die elektronische Vorrichtung (32) zu stützen, wenn die elektronische Vorrichtung (32) an dem Verbinder (30) montiert ist, wobei das Scharniermittel (42) dazu eingerichtet ist, die plattenförmige Montagesektion (40) in zwei Abschnitte (40a, 40b) zu unterteilen.

2. Verbinder (30) nach Anspruch 1, wobei das Scharniermittel (42) eine Scharnierstange umfasst, die drehbar an mindestens einem Abschnitt der Stützstruktur (38) gestützt ist, oder wobei das Scharniermittel (42) eine Sektion (42a) aus elastisch verformbarem Material umfasst.

3. Verbinder (30) nach einem der vorangehenden Ansprüche, wobei mindestens eine der ersten Eingriffnahmewand (48) und der zweiten Eingriffnahmewand (52) mindestens eine gekrümmte Sektion umfasst.

4. Verbinder (30) nach einem der vorangehenden Ansprüche, wobei die Stützstruktur (38) mindestens ein Haltemittel (58, 60, 66) zum Halten der elektronischen Vorrichtung (32) an der Stützstruktur (38) umfasst, wenn die elektronische Vorrichtung (32) an dem Verbinder (30) montiert ist.

5. Verbinder (30) nach Anspruch 4, wobei mindestens ein Haltemittel (58, 60, 66) in jedem der Abschnitte (40a, 40b) der plattenförmigen Montagesektion (40) angeordnet ist.

6. Verbinder (30) nach einem der vorangehenden Ansprüche, wobei der Verbinder (30) mindestens ein Blockiermittel (72) zum Blockieren des Scharniermittels (42) mindestens im gestreckten Zustand umfasst.

7. Elektronische Baugruppe (34) für einen Behälter (12), der einen gerundeten Querschnitt (C) umfasst, umfassend:
einen Verbinder (30) nach einem der vorangehenden Ansprüche und
eine elektronische Vorrichtung (32), insbesondere eine elektronische Verfolgungsvorrichtung (36), wobei die elektronische Vorrichtung (32) an der Stützstruktur (38) des Verbinders (30) montiert ist.

8. Elektronische Baugruppe (34) nach Anspruch 7, wobei sich der Verbinder (30) im gestreckten Zustand befindet und die elektronische Vorrichtung (32) das Scharniermittel (42) im gestreckten Zustand immobilisiert.

9. Behälteranordnung (10), umfassend:
einen Behälter (12) mit einem Speichervolumen (14), das von einer umfänglich geschlossenen Ummantelung (16), die einen gerundeten Querschnitt (C) definiert, und einer Endplatte (18), die an einem Ende der Ummantelung (16) angeordnet ist, begrenzt ist, und einen umfänglich geschlossenen Bund (24), der sich von der Endplatte (18) auf einer Seite erstreckt, die dem Speichervolumen (14) gegenüberliegt, wobei der Bund (24) einen Randabschnitt (26) aufweist, der in Richtung eines Inneren des Bundes (24) gebogen ist, und
einen Verbinder (30) nach einem der Ansprüche 1 bis 6,
wobei die erste Eingriffnahmewand (48) den Randabschnitt (26) des Bundes (24) in Eingriff nimmt, und
wobei die zweite Eingriffnahmewand (52) eine Verbindungsregion (54) des Behälters (12) zwischen der Endplatte (18) des Behälters (12) und dem Bund (24) in Eingriff nimmt.

10. Behälteranordnung (10) nach Anspruch 9, des Weiteren umfassend eine elektronische Vorrichtung (32), insbesondere eine elektronische Verfolgungsvorrichtung (36), wobei die elektronische Vorrichtung (32) an der Stützstruktur (38) des Verbinders (30) montiert ist.

11. Behälteranordnung (10) nach Anspruch 9 oder 10, wobei die elektronische Vorrichtung (32) das Scharniermittel (42) im gestreckten Zustand immobilisiert.

12. Verfahren zum Montieren eines Verbinders (30) nach einem der Ansprüche 1 bis 6 an einem Behälter (12) mit einem Speichervolumen (14), das von einer umfänglich geschlossenen Ummantelung (16), die einen gerundeten Querschnitt (C) definiert, und einer Endplatte (18) begrenzt ist, wobei die Endplatte (18) an einem Ende der Ummantelung (16) angeordnet ist und ein umfänglich geschlossener Bund (24) sich von der Endplatte (18) auf einer Seite erstreckt, die dem Speichervolumen (14) gegenüberliegt, wobei der Bund (24) einen Randabschnitt (26) aufweist, der in Richtung eines Inneren des Bundes (24) gebogen ist, umfassend:
- Bereitstellen des Verbinders (30) in einem gebogenen Zustand oder Überführen des Verbinders in den gebogenen Zustand,
- Anordnen eines freien Endes der ersten Eingriffnahmewand (48) unter dem Randabschnitt (26) oder in der Nähe des Randabschnitts (26) und/oder Anordnen eines freien Endes der zweiten Eingriffnahmewand (52) in einer Verbindungsregion (54) des Behälters (12) zwischen der Endplatte (18) des Behälters (12) und dem Bund (24) oder in der Nähe der Verbindungsregion (54),
- Überführen des Verbinders (30) in den gestreckten Zustand dergestalt, dass die erste Eingriffnahmewand (48) den Randabschnitt (26) in Eingriff nimmt und die zweite Eingriffnahmewand (52) die Verbindungsregion (54) in Eingriff nimmt.

13. Verfahren nach Anspruch 12, des Weiteren umfassend das Montieren einer elektronischen Vorrichtung (32), insbesondere einer elektronischen Verfolgungsvorrichtung (36), an der Stützstruktur (38) dergestalt, dass die elektronische Vorrichtung (32) den Verbinder (30) im gestreckten Zustand immobilisiert.

## Revendications

1. Connecteur (30) pour connecter un dispositif électronique (32), en particulier un dispositif de suivi électronique (36), à un récipient (12) ayant une section transversale arrondie (C), le connecteur (30) comprenant :
une structure de support (38) configurée pour supporter le dispositif électronique (32),
une première paroi d'engagement (48) s'étendant à partir d'une première extrémité (44a) de la structure de support (38) et configurée pour s'engager dans une partie de bord (26) d'un collet (24) du récipient (12), et
une deuxième paroi d'engagement (52) s'étendant à partir d'une deuxième extrémité (44b) de la structure de support (38) et configurée pour s'engager dans une zone de connexion (54) du récipient (12) entre une plaque d'extrémité (18) du récipient (12) et le collet (24),
dans lequel la structure de support (38) comprend un moyen d'articulation (42) permettant au connecteur (30) de prendre sélectivement un état fléchi et un état étendu, dans lequel, dans l'état fléchi, une distance entre une extrémité libre de la première paroi d'engagement (48) et une extrémité libre de la deuxième paroi d'engagement (52) est plus petite que dans l'état étendu,
**caractérisé en ce que** la structure de support (38) comprend une section de montage en forme de plaque (40) qui est configurée pour supporter le dispositif électronique (32) lorsque le dispositif électronique (32) est monté sur le connecteur (30), dans lequel les moyens d'articulation (42) sont configurés pour diviser la section de montage en forme de plaque (40) en deux parties (40a, 40b).

2. Connecteur (30) selon la revendication 1, dans lequel le moyen d'articulation (42) comprend une tige d'articulation supportée de manière rotative sur au moins une partie de la structure de support (38) ou dans lequel le moyen d'articulation (42) comprend une section (42a) en matériau élastiquement déformable.

3. Connecteur (30) selon l'une quelconque des revendications précédentes, dans lequel au moins l'une de la première paroi d'engagement (48) et de la deuxième paroi d'engagement (52) comprend au moins une section incurvée.

4. Connecteur (30) selon l'une quelconque des revendications précédentes, dans lequel la structure de support (38) comprend au moins un moyen de maintien (58, 60, 66) pour maintenir le dispositif électronique (32) sur la structure de support (38) lorsque le dispositif électronique (32) est monté sur le connecteur (30).

5. Connecteur (30) selon la revendication 4, dans lequel au moins un moyen de maintien (58, 60, 66) est disposé dans chacune des parties (40a, 40b) de la section de montage en forme de plaque (40).

6. Connecteur (30) selon l'une quelconque des revendications précédentes, dans lequel le connecteur (30) comprend au moins un moyen de blocage (72) pour bloquer le moyen d'articulation (42) au moins dans l'état étendu.

7. Ensemble électronique (34) pour un récipient (12) ayant une section transversale arrondie (C), comprenant
un connecteur (30) selon l'une quelconque des revendications précédentes, et
un dispositif électronique (32), en particulier un dispositif de suivi électronique (36), dans lequel le dispositif électronique (32) est monté sur la structure de support (38) du connecteur (30).

8. Ensemble électronique (34) selon la revendication 7, dans lequel le connecteur (30) est **à l'état** étendu et le dispositif électronique (32) immobilise le moyen d'articulation (42) à l'état étendu.

9. Ensemble récipient (10), comprenant
un récipient (12) avec un volume de stockage (14) délimité par une coque fermée circonférentiellement (16) définissant une section transversale arrondie (C) et une plaque d'extrémité (18) disposée à une extrémité de la coque (16), et un collet fermé circonférentiellement (24) s'étendant à partir de la plaque d'extrémité (18) sur un côté opposé au volume de stockage (14), dans lequel le collet (24) présente une partie de bord (26) pliée vers l'intérieur du collet (24), et
un connecteur (30) selon l'une quelconque des revendications 1 à 6,
dans lequel la première paroi d'engagement (48) s'engage dans la partie de bord (26) du collet (24), et
dans lequel la deuxième paroi d'engagement (52) s'engage dans une zone de connexion (54) du récipient (12) entre la plaque d'extrémité (18) du récipient (12) et le collet (24).

10. Ensemble récipient (10) selon la revendication 9, comprenant en outre un dispositif électronique (32), en particulier un dispositif de suivi électronique (36), dans lequel le dispositif électronique (32) est monté sur la structure de support (38) du connecteur (30).

11. Ensemble récipient (10) selon la revendication 9 ou 10, dans lequel le dispositif électronique (32) immobilise le moyen d'articulation (42) dans l'état étendu.

12. Procédé de montage d'un connecteur (30) selon l'une quelconque des revendications 1 à 6 sur un récipient (12) avec un volume de stockage (14) délimité par une coque fermée circonférentiellement (16) définissant une section transversale arrondie (C) et une plaque d'extrémité (18), dans lequel la plaque d'extrémité (18) est disposée à une extrémité de la coque (16), et un collet fermé circonférentiellement (24) s'étendant à partir de la plaque d'extrémité (18) sur un côté opposé au volume de stockage (14), dans lequel le collet (24) présente une partie de bord (26) pliée vers l'intérieur du collet (24), consistant à :
- fournir le connecteur (30) dans un état fléchi ou transférer le connecteur (30) dans l'état fléchi,
- disposer une extrémité libre de la première paroi d'engagement (48) sous la partie de bord (26) ou à proximité de la partie de bord (26), et/ou disposer une extrémité libre de la deuxième paroi d'engagement (52) dans une zone de connexion (54) du récipient (12) entre la plaque d'extrémité (18) du récipient (12) et le collet (24) ou à proximité de la zone de connexion (54),
- transférer le connecteur (30) à l'état étendu de telle sorte que la première paroi d'engagement (48) s'engage dans la partie de bord (26) et que la deuxième paroi d'engagement (52) s'engage dans la zone de connexion (54).

13. Procédé selon la revendication 12, consistant en outre à monter un dispositif électronique (32), en particulier un dispositif de suivi électronique (36), sur la structure de support (38) de telle sorte que le dispositif électronique (32) immobilise le connecteur (30) dans l'état étendu.
